# EUROPEAN PATENT APPLICATION

(11) **EP 2 332 684 A1**
(43) Date of publication of application: **15.06.2011**
(21) Application number: 10194170.6
(22) Date of filing: 08.12.2010
(51) Int. Cl.: B23K 1/00, B23K 1/19, B23K 1/20, B23K 35/30, G21B 1/00

(54) **Method of manufacturing high-heat-load equipment by metallurgically joining carbon material with copper-alloy material**

(30) Priority: 09.12.2009 JP 2009279523
(71) Applicant: Kawasaki Jukogyo Kabushiki Kaisha, Kobe-shi, Hyogo (JP)
(72) Inventor: Uchiyama, Naoki, Koto-ku Tokyo 136-8588 (JP); Yamada, Hirokazu, Koto-ku Tokyo 136-8588 (JP); Mohri, Kensuke, Koto-ku Tokyo 136-8588 (JP); Nakae, Tamotsu, Echi-gun Shiga 529-1202 (JP); Nakamori, Youichi, Echi-gun Shiga 529-1202 (JP); Kubota, Makoto, Echi-gun Shiga 529-1202 (JP)
(74) Representative: Collin, Jérôme

(57) **Abstract**

A method of manufacturing high-heat-load equipment including a carbon material (11) and a copper alloy material (16) which are joined with each other includes: forming a titanium thin layer (12) on a surface of the carbon material (11); positioning the carbon material so that the titanium thin layer (12) is opposed to the copper alloy material (16) while an interlayer (14) is Interposed between the carbon material (11) and the copper alloy material (16); inserting a brazing material sheet (13,15) into a space between the carbon material (11) and the interlayer (14), as well as into a space between the interlayer (14) and the copper alloy material (16), so as to prepare an assembly of the materials; and subjecting the assembly to a vacuum brazing process and further to an aging process.

## Description

### CROSS REFERENCE TO RELATED APPLICATIONS

This application is based upon and claims the benefit of priority from the prior Japanese Patent Application No. 2009-279523 filed on December 9, 2009, the entire contents of which are incorporated herein by reference.

### TECHNICAL FIELD

The present invention relates to a method of joining a carbon material with a copper or copper alloy material in order to manufacture high-heat-load equipment, In particular, this invention relates to a method of manufacturing the high-heat-load equipment by metallurgically joining a carbon-material block that can serve as a heat-receiving part with a cooling tube formed of a copper alloy and provided as a heat-sink part, in order to produce a divertor adapted for receiving a considerably high heat load, among equipment provided in a reactor of a nuclear fusion device.

### BACKGROUND ART

Generally, the divertor of the nuclear fusion device is provided with heat changed from kinetic energy of charged particles coming into the divertor, and is hence configured for receiving the highest heat load, among the equipment provided in the reactor of the nuclear fusion device. Therefore, this divertor is required to have a function for well enduring such a high heat load and adequately remove the heat therefrom. Additionally, for some nuclear fusion experimental devices, each designed for performing a long-time electrical discharge, the surface temperature of a component constituting the divertor may tend to exceed the melting point thereof. Therefore, a proper approach has been employed for forcibly cooling such a component, such as by cooling it with water or the like means.

In order to achieve the function of the divertor required for removing the heat of the high heat load, it is necessary to prepare the heat receiving part or equipment of the divertor by using a material having good heat conductivity. Further, for protecting a cooling structure from a heat impact caused by sputtering and/or plasma disruption due to ion radiation, the divertor is provided with an armor tile (or tiles) on its surface.

Generally, the armor tile is formed of a certain material having a small atomic number, especially a proper carbon-based material, that can less affect in nature the plasma produced in the system. This is because some particles may tend to be generated and scattered from the surface of the armor tile into the plasma by the effect of the sputtering or the like, leading to rather degradation of the temperature and/or containment properties of the plasma.

Therefore, such an armor tile is preferably formed of a carbon fiber reinforced carbon fiber composite material (CFC material) having higher heat conductivity. Further, this armor tile has the cooling tube provided therein, wherein the cooling tube is formed of a copper alloy, such as chromium-zirconium copper (CuCrZr) or the like, exhibiting relatively high heat conductivity and strength. As such, the heat received by the carbon material can be effectively removed by cooling water.

However, the carbon material generally has poor joining ability or properties to the copper alloy. Therefore, for efficiently conducting the heat received from the plasma to the cooling tube, it is necessary to metallurgically join the armor tile with the cooling tube, thereby providing a structure that can possibly reduce the heat resistance.

More specifically, in order to absorb or cancel the difference in the expansion coefficient between the armor tile formed of the carbon material and the cooling tube formed of the copper alloy, an Interlayer formed of a copper material is provided or inserted between the armor tile and the cooling tube, and then these materials are firmly joined together, such as by brazing or the like, with a material for joining mainly containing a Cu-Mg based and/or Ti-Cu based material and having the good heat conductivity.

However, during a relatively high-temperature process for producing such an armor tile, the carbon material may tend to be cracked, and/or unwanted peeling between the interlayer and the carbon material may tend to occur, due to the difference in the expansion coefficient still remaining between the carbon material and the copper alloy, and/or due to insufficient strength of the carbon material. This may lead to substantial degradation of the yield. In addition, a brazing material used for the aforementioned brazing process or the like should be formed into a considerably thin layer or sheet, making it rather time-consuming and laborsome to prepare an assembly of the materials or components respectively used for the joining process. Therefore, this method cannot be appropriate for the mass production.

JP8-506315T (Patent Document 1) discloses a part or component having a highly heat-resisting structure, wherein a graphite portion (or layer) and a metallic portion (or layer) are bonded relative to each other, via a brazing layer (or brazing material layer). Moreover, an intermediate layer composed of an alloy obtained by adding copper and/or nickel to chromium is provided between the metallic layer and the brazing layer. Namely, the provision of this special intermediate layer is intended to absorb or cancel the difference in the expansion coefficient between the graphite layer and the metallic layer respectively formed of different materials, thereby firmly bonding the two layers together.

It is true that the part or component having such a highly heat-resisting structure as disclosed in the Patent Document 1 can effectively endure a heat cycle load that the part will undergo during the operation of the nuclear fusion reactor. As such, occurrence of undue deformation and/or cracks in this part can be successfully prevented. However, a quite high-temperature process required for producing such a part may tend to damage the part, thus degrading the yield of the product.

Various problems were found out from our study on a test sample, which was prepared by arranging approximately ten or more mono-blocks, each formed of the carbon fiber reinforced carbon fiber composite material (CFC material) and having a through-hole formed therein, in series, along and around one cooling tube formed of a precipitation hardening copper alloy (CuCrZr), with a cylindrical interlayer formed of oxygen free copper being provided or inserted between the cooling tube and each mono-block. For instance, from an aging test at 480°C on the sample after it was subjected to vacuum brazing at 985°C and then quenched to maintain the strength of the precipitation hardening copper alloy, we found that each side face of the CFC blocks has been cracked in the axial direction thereof at a considerably high ratio, as well as found backlash of each CFC block caused by insufficient brazing at a relatively high ratio in the circumferential direction of the cooling tube. Further, even in the case in which the sample appeared from its external appearance to be adequately brazed, a cutting test on this sample sometimes showed that each CFC block was connected with the cooling tube by only about one-third of the circumferential length thereof.

The peeling that may cause serious degradation of the heat conductivity was mostly seen in the brazing material layer provided or inserted between each CFC block and the interlayer. For instance, in the above sample, the carbon material and copper interlayer were directly brazed together with the brazing material containing a relatively large amount of titanium (e.g., the brazing material having a composition of 60Ti-15Cu-25Ni).

In order to maintain the strength of the cooling tube formed of the precipitation hardening copper alloy, it was necessary to subject this cooling tube to the so-called solution heat treatment, in which the cooling tube was appropriately heated and then quenched. More specifically, the cooling tube should be quenched with a gradient of 1°C/second or greater in a heating furnace, immediately after the brazing process. As a result, considerably great tension was generated in the brazing material layer due to the difference in the expansion coefficient between the carbon material and the copper alloy, thus causing a titanium compound layer included in the brazing material to be pealed off from the other metallic compound layer.

For solving such problems, we have reported previously in JP2009-192264A (Patent Document 2) about one approach for manufacturing the high-heat-load equipment by metallugically joining the carbon material with the copper alloy material, Specifically, in this method, a proper metal layer having good joining ability or properties to the carbon material is first formed on the surface of the carbon material, and the so-formed metal layer is positioned to be opposed to the copper alloy material via the interlayer, and then a brazing material sheet is inserted in a space between the carbon material and the interlayer as well as inserted in a space between the interlayer and the copper alloy material, so as to prepare an assembly, and finally the so-prepared assembly is subjected to the brazing and aging processes,

More specifically, In the method of manufacturing the high-heat-load equipment disclosed in the above Patent Document 2, the metal layer formed on the surface of the carbon material is obtained by first preparing a paste or solution of proper metal powder containing copper.and titanium, coating this paste or solution onto the surface of the carbon material that will be opposed to the interlayer, and then sintering the metal components contained in the coated paste or solution at 800°C to 2000°C in an inert gas atmosphere so as to form the metal layer, and finally flattening and smoothing by machining the surface of the so-formed metal layer to be joined with the copper alloy material,

Namely, this metal layer is formed on the surface of the carbon material in order to provide a titanium carbide layer between the carbon material, and the copper alloy material, thereby to enhance the bonding ability between the two materials. However, it **is** preferred that the content of titanium in this metal layer is controlled to be possibly low relative to the content of copper. For instance, the composition of this metal layer preferably comprises approximately 2 to 10% by weight of titanium.

Therefore, according to the method of manufacturing the high-heat-load equipment as disclosed in the above Patent Document 2, the high-heat-load equipment can be manufactured more securely by metallurgically joining the carbon material, which would be otherwise less likely to be joined to the metallic layer, with the copper alloy. In particular, for the divertor of the nuclear fusion reactor, each carbon material block can be joined, in a rather desired condition, with the cooling tube formed of the copper alloy.

However, in such a method of manufacturing the high-heat-load equipment as disclosed in the Patent Document 2, the machining process has to be provided to the joining surface of the carbon material for ensuring a proper clearance and an adequately smoothed surface, both suitable for the joining with the cooling tube, after the paste or solution of the metal powder (i.e., the raw material of the metal layer) is coated onto the joining surface of the carbon material and then sintered in a high-temperature furnace. In this case, upon the coating of the raw material of the metal layer onto the joining boundary surface of the carbon material, .such a metal layer material is usually coated by handwork with an appropriate brush or pallet. Therefore, this coating work requires considerably high experience and skill of the worker. Besides, the metal layer may tend to be peeled during the machining process, still making it difficult to provide such a metal layer in an adequately stable condition. Namely, the yield of the joined product of the carbon material and copper alloy has not been so high (e.g., 50% or so), leaving room for further improvement.

### DISCLOSURE OF THE INVENTION

Therefore, it is an object of the present invention to provide an improved method of manufacturing the high-heat-load equipment by metallurgically joining the carbon material, which is less likely to be joined to the metallic layer, with the copper alloy material via a new metal layer formed on the surface of the carbon material. Specifically, the method of this invention features to use a new approach for forming the metal layer, which is basically different from the conventional method. More specifically, with the use of this approach of the present invention, the time required for forming the metal layer can be significantly shortened, while the metal layer can be formed in an adequately stabled condition, thereby joining more securely the carbon material with the copper alloy. In particular, the method of this invention is intended for joining each carbon material block with the cooling tube formed of the copper alloy in a highly desired condition in the divertor of the nuclear fusion device.

Namely, the present invention is the method of manufacturing high-heat-load equipment including a carbon material and a copper alloy material which are joined with each other, including the steps of: forming a titanium thin layer on a surface of the carbon material; positioning the carbon material so that the titanium thin layer is opposed to the copper alloy material while an interlayer is Interposed between the carbon material and the copper alloy material; inserting a brazing material sheet into a space between the carbon material and the interlayer, as well as into a space between the interlayer and the copper alloy material, so as to prepare an assembly of the materials; and subjecting the assembly to a vacuum brazing process and further to an aging process.

According to this method of this invention, by forming the titanium thin layer as the metal layer on the surface of the carbon material, the titanium contained in the titanium thin layer can be reacted in a high temperature condition with the carbon contained in the carbon material, thereby forming a substantially homogeneous titanium-carbide (Ti-C) layer on the surface of the carbon material. By the way, the original metal layer does not contain copper. However, the titanium contained in the metal layer, i.e., the titanium thin layer, can be reacted with the melted copper contained In the inserted brazing material under the high temperature condition, thereby forming a eutectic crystal. Thus, the copper contained in the brazing material can be infiltrated into the titanium thin layer and eventually contacted with the titanium carbide. Since, the titanium carbide has good wettability to the copper, the copper can be further infiltrated into each gap formed in the titanium carbide. Meanwhile, in such a high temperature condition, a part of the copper present around the surface of the interlayer will be melted and integrated with the copper contained in the brazing material.

Therefore, in a low temperature condition provided after the aging process, the interlayer and brazing material, the brazing material and titanium carbide on the' surface of the carbon material, and the titanium carbide and carbon material can be firmly joined together, respectively. In this way, the interlayer formed of the copper alloy can be firmly joined with the carbon material.

The titanium thin layer on the surface of the carbon material can be formed by utilizing a known vapor deposition method, such as the vacuum deposition, Ion deposition (or ion plating) or the like, while the thickness and/or surface condition of this layer can be securely controlled with ease. In addition, the titanium thin layer formed by the deposition method can have a smooth surface required for the metal brazing process, exhibiting desirable uniformity over the whole surface thereof.

From our experiment, it was found that the copper contained in the brazing material can be infiltrated into a desirably deep portion of the titanium carbide layer. Further, we found that it is necessary to prepare the titanium layer having a thickness of 20µm or more for firmly joining the carbon material with the interlayer. However, we also found that the titanium thin layer having the thickness of 30µm or more can no longer provide the effect of further enhancing the joining ability, Contrary, such an unduly increased thickness tends to cause rather accumulation of unwanted stress, such as thermal stress, internal stress or the like, leading to the peeling of the layer. ln addition, because of relatively low heat conductivity of the titanium-copper eutectic crystal, it is preferred to carefully control the thickness of the titanium thin layer not to be increased more than needed. Of course, the time and cost required for the production should be increased with the increase of the thickness of the titanium thin layer.

Therefore, the thickness of the titanium thin layer formed on the surface of the carbon material is preferably controlled within a range of from 20µm to 30µm.

It is true that the titanium contained in the titanium thin layer can be bonded with the carbon contained in the carbon material so as to form the titanium carbide, thereby serving as a joining agent for the carbon material for enhancing the bonding ability or properties of the carbon material to the copper alloy. However, it is also true that the unduly increased thickness of the titanium thin layer tends to cause the disturbance of joining between the layered materials and thus degrade the joining ability thereof. Therefore, what is important in the method of this invention is to adequately control the thickness of the titanium thin layer. From this view point, the method of this invention employs the ion deposition or the like. Namely, such an ion deposition of the like method can readily control the thickness of the layer or film to be deposited for a predetermined time, as well as can provide a significantly smooth and homogeneous joining surface. Therefore, this method can eliminate the machining process as required in the conventional method after the formation of the metal layer, as well as can substantially reduce the number of the steps required for the production.

In the method of this invention, the high-heat-load equipment may be the divertor for use in the nuclear fusion reactor, the carbon material may be a mono-block type armor tile having the through hole and formed of the carbon fiber reinforced carbon composite material (CFC material), the copper alloy may be the cooling tube formed of the precipitation hardening copper alloy, and the interlayer may be the cylindrical interlayer formed of the oxygen free copper.

Preferably, the brazing material used for joining the carbon material with the interlayer contains copper, According to the method of manufacturing the high-heat-load equipment of this invention, the high-heat-load equipment including the carbon material and copper alloy material, both firmly joined relative to each other, can be provided with a highly improved yield. In particular, the method of manufacturing the high-heat-load equipment of this invention can be applied to produce the divertor including the mono-block type armor tiles, each joined with the cooling tube in order to effectively remove the heat generated therefrom.

### BRIEF DESCRIPTION OF THE DRAWINGS

The above and other objects, features and advantages of the present invention will become more apparent from the following description taken in connection with the accompanying drawings, in which:
Fig. 1 is a perspective view of a divertor of a nuclear fusion reactor of which a portion of one armor tile is partly sectioned at a position designated by line I-I in Fig. 3, the divertor being produced in accordance with an embodiment of the method of manufacturing the high-heat-load equipment according to the present invention;
Fig. 2 is an exploded view showing respective components of the divertor produced in accordance with the method of manufacturing the high-heat-load equipment of the above embodiment;
Fig. 3 is a diagram illustrating an assembly of the divertor produced in accordance with the method of manufacturing the high-heat-load equipment of the above embodiment;
Fig. 4 is an exploded view showing members or parts, respectively used for assembling each armor tile prepared in accordance with the method of manufacturing the high-heat-load equipment of the above embodiment;
Fig. 5 is a flow chart illustrating a procedure of the method of manufacturing the high-heat-load equipment of the above embodiment;
Fig. 6 is a diagram illustrating general construction of an ion deposition device used in the method of manufacturing the high-heat-load equipment of the above embodiment; and
Fig. 7 is a diagram illustrating a mechanism for joining the carbon material with copper in the method of manufacturing the high-heat-load equipment according to this invention.

### DETAILED DESCRIPTION OF THE INVENTION

Hereinafter, the method of manufacturing the high-heat-load equipment according to the present invention will be described with respect to one exemplary embodiment. The method of this embodiment is intended for metallurgically joining each armor tile formed of the carbon fiber reinforced carbon fiber composite material (CFC material) with a cooling water pipe formed of the copper alloy in the divertor used in the nuclear fusion reactor. More specifically, the method of this embodiment is designed for inserting the interlayer containing copper into a space between an inner wall around the through hole of the CFC block, i.e., the carbon material, constituting each armor tile and an outer wall of the cooling tube, and then fixing these components relative to one another by subjecting the assembly of such components to the vacuum brazing with the brazing material containing copper. In this case, this method features that the titanium thin layer is formed on the inner wall surface around the through hole of each CFC block. For instance, this titanium thin layer can be formed, by utilizing the vapor deposition, such as the ion deposition or the like, of a proper titanium metal onto the surface of each CFC block.

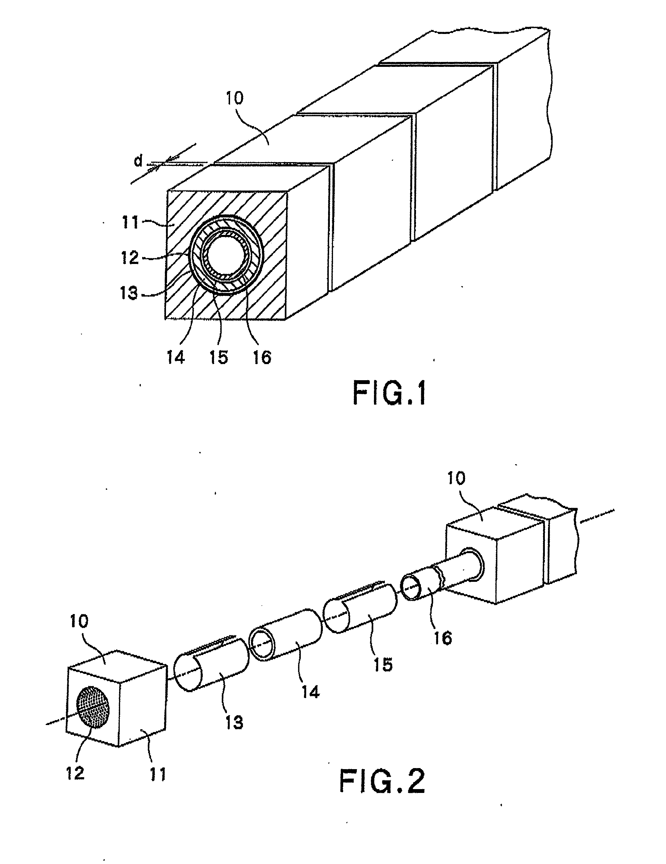

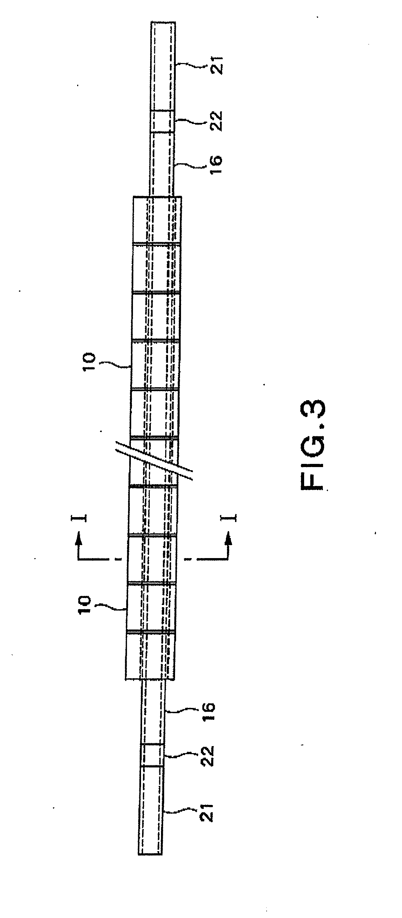

As shown in Figs. 1 to 3, the divertor that can serve as the heat-receiving part includes several tens of armor tiles 10 as the components thereof. In this case, the armor tiles 10 are respectively arranged and fixed around one cooling tube 16 with the gap d of approximately 0.5mm to 1.0mm.

Each armor tile 10 is composed of the CFC block having a mono-block structure and formed of the carbon fiber reinforced carbon fiber composite material (CFC material). In this case, each carbon fiber of the CFC block is oriented vertically to each heat load surface facing toward the inside of the nuclear fusion reactor. It is noted that the heat load surface of each armor tile 10 has a rectangular or square shape with one side of an approximately 20mm to 30mm length.

In the CFC block 11 of each armor tile **10,** the through hole having a diameter of approximately 15mm to 20mm is formed with the titanium thin layer 12 formed on the surface of the armor tile 10 around the through hole.

The cooling tube 16 extends through the through hole of each CFC block. This cooling tube 16 has a wall thickness of approximately 1.5mm and is formed of the copper alloy of a relatively high heat transfer coefficient. In this case, the cooling tube 16 Is provided for removing the heat transferred from each armor tile 10 by using the cooling water flowed through the cooling tube 16. Preferably, the cooling tube 16 is formed of the chromium-zirconium copper (CuCrZr) having a relatively high heat transfer coefficient and high strength.

The interlayer 14 is inserted in the space between the CFC block 11 of each armor tile 10 and the cooling tube 16. Then, the cooling tube 16 and interlayer 14, and the interlayer 14 and each CFC block 11 are fixed together, respectively, by brazing.

The interlayer 14 is formed of the oxygen free copper or copper alloy and has a cylindrical shape. This interlayer 14 can serve to absorb or cancel the difference in the coefficient of thermal expansion between each CFC block and the cooling tube 16.

At each end of the cooling tube 16, a connector for cooling tube 21 formed of stainless steel is attached via an insert tube 22 formed of a nickel alloy.

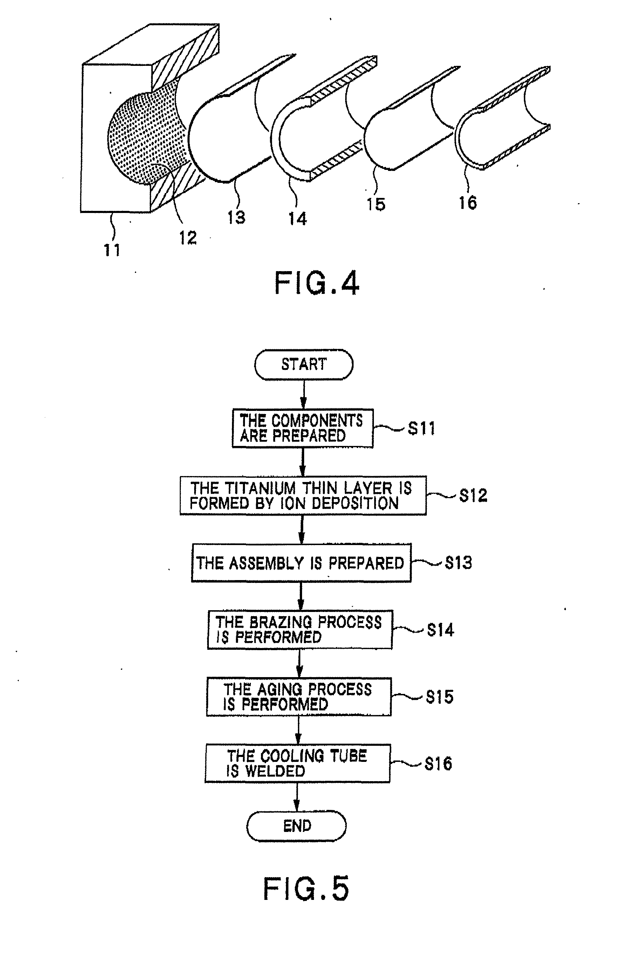

Fig. 4 is an exemplary exploded view showing the members or parts, respectively used for assembling each armor tile of the divertor produced in accordance with the method of manufacturing the high-heat-load equipment of this embodiment, wherein each member or part is depicted as one cut in half.

This embodiment is designed for joining and fixing the cooling tube 16 to the interlayer 14 as well as joining and fixing the interlayer 14 to the CFC block 11 of each armor tile 10, respectively, by vacuum brazing, with the brazing material sheets 13, 15, and features that the titanium thin layer 12 is formed on the surface around the through hole of each CFC block 11.

Next, the procedure for producing the above structure In this embodiment will be described.

Fig. 5 is the flow chart illustrating one exemplary procedure in the method of manufacturing the high-heat-load equipment of this embodiment.

First of all, the CFC blocks 11, cooling tube 16, interlayer 14, brazing material sheets 13, 15 and the like are respectively prepared (S11).

The brazing material 15 inserted between the cooling tube 16 and the interlayer 14, and the brazing material 13 inserted between the interlayer 14 and each CFC block 11 respectively contain nickel, copper and manganese. Further, each of such brazing materials 13, 15 is cut from a sheet having a thickness of approximately 50µm with a width fitted for the length of the through hole of each CFC block 11, so as to be prepared as a ribbon-like sheet of the brazing material.

Thereafter, the titanium thin layer 12 Is formed by an ion deposition or the like on the Inner wall around the through hole of each CFC block 11 to be joined with the cooling tube 16 (S12). For this ion deposition process, any suitable deposition device available from various manufactures can be used.

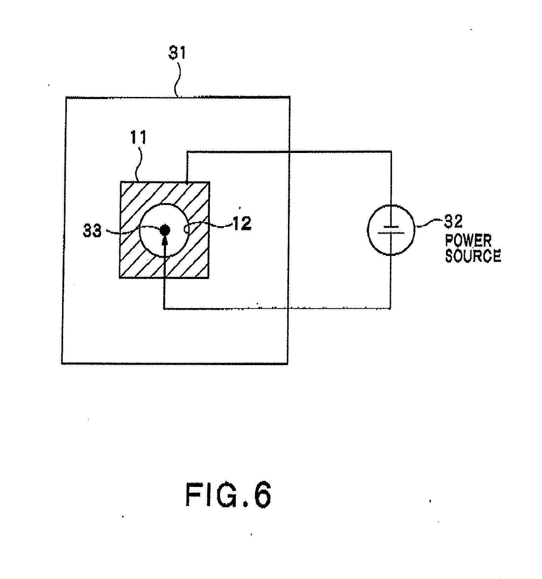

Fig. 6 schematically illustrates general construction of an exemplary ion deposition device for use in the vapor deposition of titanium onto the carbon material. This ion deposition device includes a vacuum chamber 31, a direct-current power source 32, and a target 33.

In this embodiment, each CFC block 11 is placed in the vacuum chamber 31 of the ion deposition device, and then the target 33 formed of titanium is placed In a position opposed to the inner wall surface of the CFC block 11 to be subjected to the vapor deposition. Further, the CFC block 11 and target 33 are respectively connected with the direct-current power source 32. Thereafter, a suitable direct-current voltage is applied between the CFC block 11 and the target 33 in order to evaporate titanium from the target 33. As a result, the so-evaporated titanium is deposited while being ionized onto the anode face of the CFC block 11. In this way, the titanium thin layer 12 can be formed by the vapor deposition of titanium on the Inner wall face around the through hole of each CFC block 11.

Then, the position of each CFC block 11 to be fixed along and around the cooling tube 16 is determined while the gap d between each adjacent pair of CFC blocks 11 is set at approximately 0.5mm to 1.0mm. Thereafter, the interlayer 14 is fitted in the space around the cooling tube 16 with the brazing material sheet 15 wound and attached around the inner surface of the interlayer 14. Further, the interlayer 14 is fitted and positioned around each CFC block 11 with the brazing material sheet 13 attached inside of through hole of the CFC block 11. Then, this process is repeated corresponding to the number of the CFC blocks 11, thereby preparing the assembly before the brazing process (513).

Alternatively, each brazing material sheet 13, 15 may be Inserted in each corresponding space or gap after the interlayer 14 and each CFC block 11 are assembled together.

In order to securely maintain the gap d between the CFC blocks 11 in the assembly after the assembling process, a proper spacer formed of the graphite material may be used. In this case, each spacer may be removed after the brazing process.

Then, so-obtained assembly is subjected to the vacuum brazing by heating and melting each brazing material 13, 15 in a vacuum heating furnace at a temperature higher than 925°C, e.g., approximately 1000°C (S14),

In order to equally braze the entire body of the assembly having such a complex shape and composition as described above, the assembly is preferably subjected to sufficient preheating provided at a temperature slightly lower than the above brazing temperature before the temperature reaches the brazing temperature.

Since the metal material constituting the cooling tube 16 consists of the precipitation hardening copper alloy (CuCrZr), this material tends to be softened if it is exposed to a high temperature upon the brazing process, Accordingly, such a material should be subjected to an appropriate aging after the brazing process In order to recover and ensure the hardness thereof. Therefore, such a joined body of the brazed cooling tube/CFC blocks is subjected to the aging process for a predetermined time at a suitable aging temperature of approximately 500°C in a vacuum under an inert gas atmosphere (S15).

After such an aging process, the assembly is allowed to be cooled in the furnace.

Before brazing, the connector for cooling tube 21 is attached by welding to each end of the cooling tube 16 of the joined body composed of the brazed cooling tube/CFC blocks (S16).

In this case, the connector for cooling tube 21 is formed of stainless steel, and hence less likely to be joined with the cooling tube formed of the CuCrZr alloy. Therefore, such a connector 21 is attached to each end of the cooling tube 16 by welding via the insert pipe 22 formed of a suitable nickel alloy.

The titanium contained in the titanium thin layer 12 of each CFC block 11 can produce a titanium compound, such as titanium carbide or the like, when reacted with carbon components contained in the CFC block 11. Thus, this titanium thin layer 12 can be firmly joined with each CFC block 11.

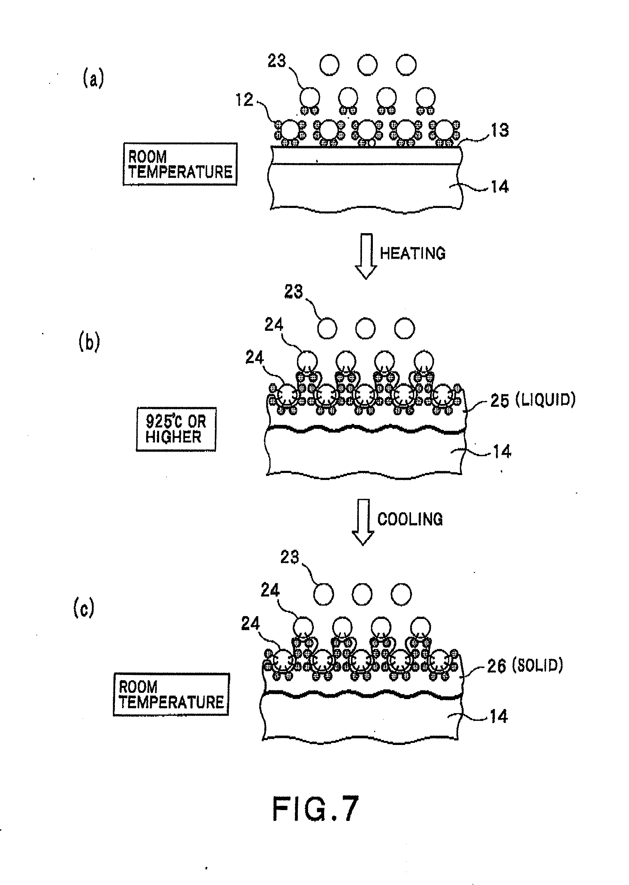

Fig. 7 is provided herein for illustrating the mechanism for joining the carbon material with the copper material in the method of manufacturing the high-heat-load equipment according to this invention.

Fig. 7(a) shows a normal temperature condition before the assembly is subjected to the brazing process. As shown in Fig. 7(a), the titanium thin layer 12 is deposited on the surface of the carbon components 23, such as the carbon fibers or the like, included in each CFC block 11. Further, this titanium layer is covered with the brazing material 13, while the brazing material 13 is in turn covered with the interlayer 14. In this state, when this assembly is heated for the brazing process at the temperature higher than 925°C, each carbon component 23 contacted with titanium will be changed through a chemical reaction into the titanium carbide 24.

In general, the titanium carbide has good wettability to a liquefied metallic component. Meanwhile, the copper contained in the brazing material 13 tends to produce a titanium-copper eutectic crystal 25 having a relatively low melting point together with the titanium contained in the titanium thin layer 12. Therefore, so-produced eutectic crystal 25 tends to be liquefied at a considerably high temperature, exhibiting adequate flowability. Thus, in a high temperature condition during the brazing, as shown in Fig. 7(b), the liquefied titanium-copper eutectic crystal 25 can be well infiltrated into each polas formed in the titanium carbide.

Thereafter, as shown in Fig. 7(c), the titanium-copper eutectic crystal 25 is cooled up to the room temperature, and thus solidified together with the brazing material 13 into a solid 26. In this way, appropriate joining ability or properties between such a brazing material 13 and each CFC block 11 containing the carbon components 23 can be ensured.

Further, as shown in Fig. 7(b), the copper contained in the interlayer 14 is also melted on and around the surface of the interlayer 14 contacting with the brazing material 13 Including the titanium-copper eutectic crystal 25 melted due to the high temperature condition during the brazing, as such can be well fused with the copper contained in the brazing material 13. Therefore, when cooled up, as shown in Fig. 7(c), the interlayer 14 and the solidified brazing material 13 can be integrated enough with each other, exhibiting further enhanced joining ability or properties.

Similarly, the joining properties between the interlayer 14 and the brazing material 15 as well as those between the brazing material 15 and the cooling tube 16 can be ensured adequately.

Therefore, unlike the conventional method designed for joining the carbon material with the copper alloy by using only the metal layer, each armor tile portion of the divertor produced in this embodiment has the titanium thin layer 12 deposited on the CFC block 11. Therefore, even in the case of undergoing rather great thermal stress due to the temperature change during the production, the above configuration according to this embodiment can successfully joint between each CFC block 11 and the brazing material 13 and/or interlayer 14.

From the result of our experiment, we found that it is necessary to provide the titanium thin layer 12 having the 20µm or more thickness for achieving an adequate liquid phase reaction between titanium and copper. However, because of the relatively low heat conductivity of the titanium-copper eutectic crystal, it is preferred to carefully control the thickness of the titanium thin layer not to be increased more than needed. Further, upon the production of the titanium thin layer 12, unwanted stress, such as thermal stress, internal stress and the like, may tend to be accumulated in the layer 12 with increase of the thickness thereof, and such accumulation of the stress may tend to cause the unwanted peeling in the resultant carbon-metal layered structure. Additionally, it should be noted that the increase of the thickness of the titanium thin layer 12 leads to lengthening the time required for the production, while substantially increasing the cost.

Further, we also found that the bonding ability or properties cannot be further improved even if the thickness of the titanium thin layer 12 is increased up to 30µm or more.

From such circumstances, the thickness of the titanium thin layer 12 is preferably controlled within the range of from 20µm to 30µm.

Generally, the ion deposition process can readily control the thickness of the resultant metal layer. For instance, the variation in the thickness of the titanium thin layer 12 can be controlled within a range of about ±3µm. Therefore, it is relatively easy to control the thickness of the titanium thin layer 12 within the range of from 20µm to 30µm, while a target value of the thickness is set at 25µm with the variation of this target thickness being set within a range of ±5µm.

In addition, such an ion deposition process can provide a substantially smooth and homogeneous joining surface, thereby well stabilizing the metallurgical joining between the carbon material and the interlayer formed of the oxygen free copper or copper alloy, via the metal brazing material. Thus, this ion deposition process is well suitable for the mass production.

Further, in this embodiment, the formation of the titanium thin layer 12 by utilizing the ion deposition process can eliminate the machining process that may be otherwise required after the formation of the titanium thin layer, thereby significantly reduce the work requiring high experience and skill of the worker, as such substantially reducing the number of the steps required for the entire work. In addition, the yield can be significantly improved, usually up to 80%, and occasionally up to around 100%.

Further, unlike the conventional art that has often experienced the occurrence of the peeling in the carbon-metal layered structure as well as the occurrence of the cracks in each armor tile, the method of manufacturing the high-heat-load equipment according to this embodiment utilizes the titanium thin layer 12 that is designed to have an adequately thin thickness after the completion of the product as well as to be chemically changed into such a titanium-copper eutectic crystal layer that can eliminate the boundary face between the pure titanium of the layer 12 and the copper material. Therefore, the method according to this embodiment can successfully prevent the occurrence of the peeling or the like, thereby providing the divertor component having excellent durability against the damage that may be otherwise caused during the operation of the nuclear fusion reactor.

Namely, by utilizing the method of this embodiment, the titanium contained in the titanium thin layer is reacted and bonded with the carbon contained in the surface of the carbon material, so as to form the titanium carbide. Further, the titanium contained in the titanium thin layer is also reacted with the copper contained in the brazing material, so as to form the eutectic crystal that can be melted under such a high temperature condition at the brazing. Therefore, the liquefied titanium-copper eutectic crystal can be infiltrated and fixed in each gap formed in the titanium carbide. Furthermore, the brazing material can be well fused and bonded with the interlayer.

Namely, the copper or titanium-copper eutectic crystal and titanium carbide have good wettability relative to each other. Therefore, such copper or titanium-copper eutectic crystal can be well infiltrated into each gap formed in the titanium carbide produced on and around the surface of the carbon material, as such can be firmly bonded with the carbon material when solidified. Meanwhile, the interlayer can also be firmly bonded with the cooling tube formed of the copper alloy via the brazing material containing the copper.

In this way, the inside of hole in each CFC block, interlayer and outside of the cooling tube can be firmly bonded relative to one another, thereby providing a significantly strong divertor component including the armor tiles respectively connected in succession along and around the cooling tube.

While this embodiment employs the titanium thin layer 12 formed by depositing titanium onto the inside of hole in each CFC block, any other suitable active metal can also be used in place of the titanium, provided that such an active metal can be well reacted and changed together with copper into the eutectic crystal that can exhibit an adequately lowered melting point.

As stated above, the preferred embodiment has been described with reference to the drawings. However, it should be understood that various additions, modifications and deletions can be made to this embodiment, without departing from the scope and spirit of the invention. Therefore, it should be construed that such additions, modifications and deletions also fall within the scope of this invention.

### Industrial Applicability of the Invention

As stated above, the method of the present invention can manufacture the high-heat-load equipment including the carbon material and copper alloy that are firmly joined together, with the time required for the production process being significantly reduced, as well as with the yield of the product being highly improved. In particular, the method of manufacturing the high-heat-load equipment according to this invention can be applied to the production of the divertor used for the nuclear fusion reactor and including the mono-block type armor tiles, each joined with the cooling tube in order to effectively remove the heat generated therefrom.

## Claims

1. A method of manufacturing high-heat-load equipment including a carbon material and a copper alloy material which are joined with each other, comprising the steps of:
forming a titanium thin layer on a boundary surface for brazing of the carbon material;
positioning the carbon material so that the titanium thin layer Is opposed to the copper alloy material while an interlayer is interposed between the carbon material and the copper alloy material;
Inserting a brazing material sheet into a space between the carbon material and the interlayer, as well as into a space between the interlayer and the copper alloy material so as to prepare an assembly of the materials; and
subjecting the assembly to a vacuum brazing process and further to an aging process.

2. The method of manufacturing the high-heat-load equipment according to claim 1,
wherein the high-heat-load equipment is a divertor for use in a nuclear fusion reactor,
wherein the carbon material is a mono-block type armor tile having a through hole and formed of a carbon fiber reinforced carbon fiber composite material (CFC material),
wherein the copper alloy material is a cooling tube extending through the through hole of the armor tile and formed of a precipitation hardening copper alloy, and
wherein the interlayer is a cylindrical interlayer formed of oxygen free copper or copper alloy.

3. The method of manufacturing the high-heat-load equipment according to claim 1 or 2, wherein the titanium thin layer has a thickness within a range of from 20µm to 30µm.

4. The method of manufacturing the high-heat-load equipment according to any one of claims 1 to 3, wherein the
titanium thin layer is formed by depositing titanium onto the surface of the carbon material.

5. The method of manufacturing the high-heat-load equipment according to any one of claims 1 to 4, wherein the brazing material inserted between the carbon material and the interlayer contains copper.
